(19) Europäisches Patentamt

European Patent Office

Office européen des brevets

(11) **EP 2 631 913 A2**

(12) **EUROPEAN PATENT APPLICATION**

(43) Date of publication:
**28.08.2013 Bulletin 2013/35**

(51) Int Cl.:
*G11C 11/16* (2006.01)     *H01F 10/32* (2006.01)
*H01L 29/66* (2006.01)     *H01L 43/08* (2006.01)
*H01L 27/22* (2006.01)

(21) Application number: **12172627.7**

(22) Date of filing: **19.06.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **27.02.2012 EP 12157109**
**01.03.2012 EP 12157773**

(71) Applicant: **Hitachi Ltd.**
**Tokyo (JP)**

(72) Inventors:
• **Wunderlich, Joerg**
  **Cambridge**
  **Cambridgeshire CB3 0HE (GB)**

• **Ferguson, Andrew**
  **Cambridge**
  **Cambridgeshire CB3 0HE (GB)**
• **Jungwirth, Tomas**
  **162 53 Praha 6 (CZ)**
• **Chiara, Chiccarelli**
  **Cambridge**
  **Cambridgeshire CB3 0HE (GB)**

(74) Representative: **Piotrowicz, Pawel Jan Andrzej et al**
**Venner Shipley LLP**
**Byron House**
**Cambridge Business Park**
**Cowley Road**
**Cambridge CB4 0WZ (GB)**

(54) **Field-effect transistor with magnetic layer**

(57)     A field-effect transistor comprises a conductive channel (6) and first and second contacts (8, 9) to the channel, a gate electrode (4) for applying an electric field to the channel and a gate dielectric (5) separating the gate electrode from the channel. The channel comprises non-magnetic material. The channel has a length, $L_C$. The gate electrode is arranged to gate the channel substantially along the length of the channel. A region (10) of the gate which is proximate to the channel comprises a magnetically-ordered material having a chemical potential which depends on magnetic moment orientation.

Fig. 5

**Description**

The present invention relates to a field-effect transistor.

Devices which employ magnetic materials and which are used in non-volatile memory or as magnetic field sensors are known.

For example, US 5 652 445 A describes a ferromagnetic gated field-effect transistor (FET) having a gate in which a ferromagnetic layer covers a portion of the channel such that a fringe magnetic field is generated normal to the surface of the channel. The magnetic field results in a Lorentz force which is used to generate a transverse Hall voltage which can be sensed using Hall probes.

EP 1830 410 A describes a single-electron transistor comprising a channel which is divided into conductive islands and tunnel barriers, leads and a side gate. The channel, leads and gate are formed from ferromagnetic material. The single-electron transistor exhibits anisotropic magnetoresistance which not only depends on gate voltage, but also is greatly enhanced in the single-charge transport regime.

Although, the single-electron transistor described in EP 1 830 410 A *ibid.* shows considerable promise, it may not be well suited to being used in memory or logic, for example, due to the sensitivity of Coulomb blockade on random offset charges and also low source-drain currents. Furthermore, for the effect to be observed, the charging energy has to be of the order of the thermal energy, $k_BT$, (where $K_B$ is Bolzmann constant and T is temperature in Kelvin) which can limit the temperature of operation of the transistor.

According to a first aspect of the present invention there is provided a field-effect transistor comprising a conductive channel comprising a non-magnetic material, first and second contacts to the channel, a gate electrode for applying an electric field to the channel and a gate dielectric separating the gate electrode from the channel. The channel has a length and the gate region is arranged to gate the channel substantially along the length of the channel. A region of the gate which is proximate to the channel comprises a magnetically-ordered material having a chemical potential which depends on orientation of magnetic moments in the gate region.

Thus, the orientation of magnetic moments in the gate region can be used to control charge transport in a conductive channel. A change in chemical potential in the magnetically-ordered gate can have a significant impact on charge transport in a transistor which has a continuous channel (i.e. one in which the channel is not broken up into one or more discrete conductive islands and tunnel barriers) and, thus, does not exhibit Coulomb blockade.

According to a second aspect of the present invention there is provided a current-generating device comprising first and second electrodes separated by a region of dielectric material. A region of first electrode which is proximate to the second electrode comprises a magnetically-ordered material having a chemical potential which depends on orientation of magnetic moments in the region of first electrode. A region of second electrode which is proximate to the first electrode may comprise a magnetically-ordered material having a chemical potential which depends on orientation of magnetic moments in the region of second electrode.

Thus, changing the orientation of magnetic moments (for example, in the case of a ferromagnetic or ferrimagnetic material, changing magnetization) charges the first electrode. By repetitively changing the orientation of the magnetic moments of the first electrode, an ac current can be generated.

According to a third aspect of the present invention there is provided a method of operating the current-generating device. The method comprises applying a load between the first and second electrodes and changing orientation of the magnetic moments in the region of the first electrode for a given period of time and, optionally, changing orientation of the magnetic moments in the region of the second electrode for a given period of time, thereby generating a pulse. Magnetic moments can be periodically re-orientated to generate an ac current.

The change in orientation of the magnetic moments may result in a change of chemical potential of at least 1 meV, at least 2 meV, at least 5 meV or at least 10 meV.

The magnetically-ordered material may be an antiferromagnetic material.

Using an antiferromagnetic material can have the advantage that it can exhibit a large chemical potential anisotropy. The antiferromagnetic material can be exchanged-coupled to a soft ferromagnetic material having a low coercivity, for example, less than 1 mT, so that the magnetic moments in the antiferromagnetic material which are exchange coupled to the magnetic moments in the ferromagnetic material can be easily re-orientated, for example, by applying an external magnetic field acting on the magnetic moments in the ferromagnetic material.

The magnetic moments of the antiferromagnetic material can be re-oriented by applying mechanical strain to the gate electrode. Strain variation of the order of magnitude of $10^{-4}$ or larger can re-orientate magnetic moments causing a change in chemical potential.

The antiferromagnetic material may comprise an alloy comprising a Group I element, a Group II element and a Group V element. For example, the Group I element may be antiferromagnetic material may comprise CuMnAs, CuMnP or LiMnAs.

The antiferromagnetic material may comprise an alloy including a heavy transition metal, such as palladium (Pd), iridium (Ir), platinum (Pt) or gold (Au), and a magnetic element, such as iron (Fe), nickel (Ni) or cobalt (Co). The heavy transition metal may be iridium (Ir) and the magnetic element may be manganese (Mn). The thickness of the gate region has a thickness resulting in a Néel temperature ($T_N$) of at least about 290 K. For example, for IrMn (80:20), the gate region may have a thickness of at least 3 nm. The antiferromagnetic material may comprises nickel oxide (NiO). The antiferromagnetic material may comprises an alloy of two different ferromagnetic materials, such as iron (Fe), manganese (Mn) or chromium (Cr).

The magnetically-ordered material may be a ferrimagnetic material.

Using a ferrimagnetic material can have the advantage that it can exhibit a smaller stray field. A ferrimagnetic material can include a rare-earth element and so exhibit strong spin-orbit coupling and, thus, a large change of chemical potential.

The ferrimagnetic material may be an alloy including a rare earth element and a non rare earth transition element. The rare earth element may be dysprosium (Dy) or terbium (Tb) and the non rare earth transition element may be iron (Fe). The ferrimagnetic material may comprise DyFeCo or TbFeCo. The ferrimagnetic material may comprise yttrium iron garnet (YIG). The ferrimagnetic material may comprise iron oxide ($Fe_3O_4$). The ferrimagnetic material may comprise a ferrite comprising an iron oxide and other elements, such as aluminium (Al), cobalt (Co), nickel (Ni), manganese (Mn) or zinc (Zn).

The magnetic moments of the ferrimagnetic material and, thus, the magnetization of the ferrimagnetic material (which is the volume density of magnetic moment of the ferrimagnetic material) can be re-oriented by applying mechanical strain to the gate electrode. Strain variation of the order of magnitude of $10^{-4}$ or larger can re-orientate magnetic moments causing a change in chemical potential.

The magnetically-ordered material may be a ferromagnetic material. The ferromagnetic material may comprise an ordered alloy. The ferromagnetic material may comprise a multilayer structure. The ferromagnetic material may include a magnetic element and a transition element. The magnetic element may be cobalt (Co) or iron (Fe) and the transition element may be palladium (Pd), platinum (Pt) or gold (Au). Such materials tend to exhibit strong crystalline anisotropy and strong interface anisotropy. The thickness of the gate region can be adapted so that there is a weak effective anisotropy as a result from competition between interface or surface anisotropy, shape anisotropy and crystalline anisotropy of the bulk material so that it is possible to manipulate orientation of magnetic moments in a weak magnetic field.

The magnetic moments in the ferromagnetic material and, thus, the magnetization can be re-oriented by applying mechanical strain to the gate electrode. Strain variation of the order of magnitude of $10^{-4}$ or larger can re-orientate magnetic moments causing a change in chemical potential.

The gate electrode or first electrode may comprise a further region directly in contact with the region which is proximate to the channel (or second electrode), the further region comprising a ferromagnetic material.

The gate region or region of the first electrode may exhibit at least bi-axial magnetic anisotropy, for example, n-fold anisotropy magnetic anisotropy, where n $\geq$2.

The gate dielectric or dielectric may comprise a high-k dielectric material. The high-k dielectric material may be hafnium dioxide ($HfO_2$), hafnium silicate ($HfSiO_4$), zirconium dioxide ($ZrO_2$) or zirconium silicate ($ZrSiO_4$). The gate dielectric or dielectric is preferably thick enough to avoid quantum mechanical electron tunnelling through the dielectric layer. The gate dielectric or dielectric may have a thickness of at least 5 nm, at least 10 nm or at least 20 nm. The gate dielectric or dielectric may have a thickness of no more than 50 nm or no more than 100 nm.

The non-magnetic material can be a semiconductor material. The non-magnetic material may comprise graphene. The non-magnetic material may comprise silicon, for example, monocrystalline silicon.

The transistor may include a second gate. The second gate may be non-magnetic. The first gate may be a top gate and the second gate may be a bottom gate. The second gate may be magnetically-ordered. The combined gate-specific changes in chemical potentials via magnetic moment re-orientation can have a stronger effect on the channel conductance compared to the magnetic gate action of a single magnetically-ordered gate.

The gate electrode or first gate may be configured to exhibit first and second stable states, said first and second stable states having different values of chemical potential.

The gate electrode or first gate may be configured to exhibit first and second stable states, said first and second stable states having substantially the same chemical potential, the gate is further configured to switch between the first and second stable states through domain wall propagation.

According to a fourth aspect of the present invention there is provided a magnetic field sensor comprising at least one field-effect transistor.

According to a fifth aspect of the present invention there is provided a memory device comprising at least one transistor.

According to a sixth aspect of the present invention there is provided a strain sensor comprising at least one transistor.

Certain embodiments of the present invention will now be described, by way of example, with reference to the accompanying drawings, in which:

Figure 1 is a schematic view of an example of ferromagnetic material;
Figure 2 is a schematic view of an example of ferrimagnetic material;
Figure 3a is a schematic view of a first example of antiferromagnetic material;
Figure 3b is a schematic view of a second example of antiferromagnetic material
Figure 4 is a schematic plan view of a first field-effect transistor;
Figure 5 is a schematic side view of a first field-effect transistor;
Figure 6 is a schematic side view a layer structure of a gate electrode;
Figure 7 illustrates first and second orientations of magnetic moments in a gate electrode;
Figure 8a is an energy diagram for a first orientation of magnetic moments;
Figure 8b is an energy diagram for a second orientation of magnetic moments;
Figure 9 is a simulation of a transistor for different orientations of magnetic moments having different chemical potentials;
Figure 9a a schematic view of a simulated transistor;
Figure 10 is a side plan view of a second field-effect transistor;
Figure 11 illustrates propagation of a domain wall and two states of the second transistor shown in Figure 10;
Figure 12 is a schematic side view of a current-generating device;
Figure 12a illustrates prerecession of magnetic moment orientation in a gate electrode at a frequency $\omega$; and
Figure 13 is a flow diagram a process of fabricating a field-effect transistor and/or a current-generating device.

## Magnetically-order materials

Before describing certain embodiments of the present invention, some examples of magnetically-ordered materials will be briefly described.

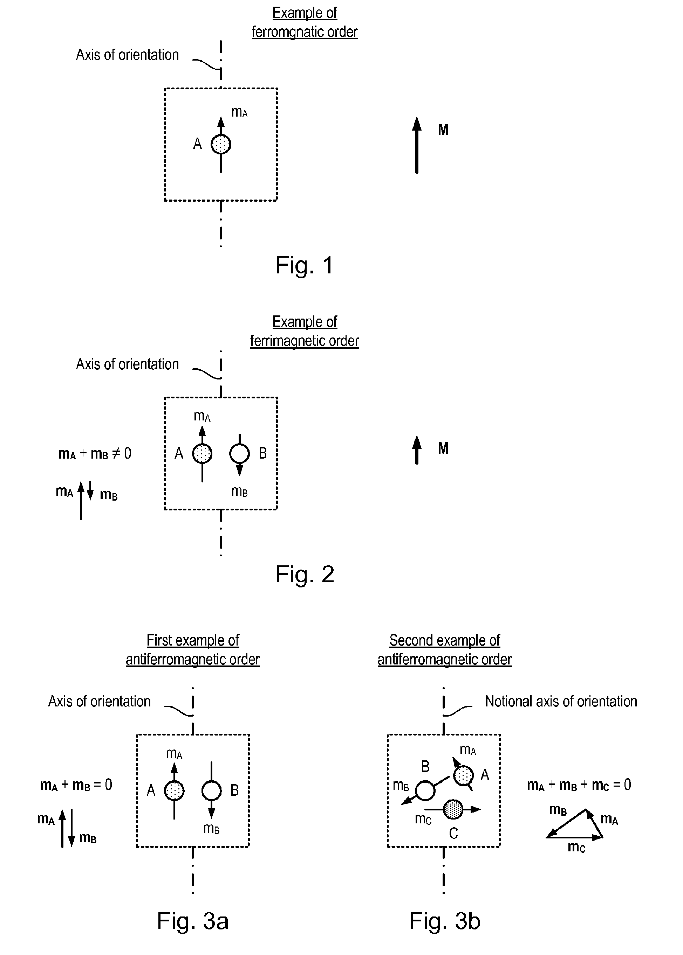

Figures 1, 2, 3a and 3b schematically show examples of magnetically-ordered materials.

Figure 1 illustrates an example of a ferromagnetic material comprising a lattice of atoms A of a magnetic element, such as iron (Fe). Each atom A in the lattice exhibits a magnetic moment, $\mathbf{m}_A$. The magnetic moments in the lattice are aligned parallel to an axis of orientation and in the same direction resulting in a spontaneous magnetization, **M.**

The example shown in Figure 1 is simple ferromagnetic material. Ferromagnetic material can have a more complex structure. For example, a ferromagnetic material may comprise a lattice formed of two or more sub-lattices of magnetic elements, such as iron (Fe) and nickel (Ni), or one or more magnetic elements and one or more non-magnetic elements. Even more complex ferromagnetic materials, magnetic moments are aligned in the same direction resulting in a spontaneous magnetization.

Figure 2 illustrates an example of a ferrimagnetic material comprising a lattice which includes a first sub-lattice which comprises atoms A of a first magnetic element and a second sub-lattice which comprises atoms B of a second magnetic element. The first and second magnetic elements A, B may be the same element (such as iron), but atoms of the element may occupy different lattice sites. An example of a ferrimagnetic material is iron (II,III) oxide ($Fe_3O_4$). Each atom A in the first sub-lattice exhibits a magnetic moment, $\mathbf{m}_A$, and each atom B in the second sub-lattice exhibits a magnetic moment, $\mathbf{m}_B$. The magnetic moments of atoms A of the first sub-lattice and the magnetic moments of atoms B of the second sub-lattices are aligned parallel to an axis of orientation but in the opposite directions. However, the magnitude of the magnetic moment of the first atom A is greater than that of the magnetic moment of the second atom B (i.e. $m_A > m_B$) resulting in a net, non-zero spontaneous magnetization, **M.**

A ferrimagnetic material can have a more complex arrangement.

Figure 3a illustrates an example of an antiferromagnetic material comprising a lattice which includes a first sub-lattice which comprises atoms A of a first magnetic element and a second sub-lattice which comprises atoms B of a second magnetic element. The first and second magnetic elements A, B may be the same element (such as manganese), but may occupy different lattice sites. Examples of antiferromagnetic materials include $Mn_2Au$ and MnIr. Each atom A in the first sub-lattice exhibits a magnetic moment, $\mathbf{m}_A$, and each atom B in the second sub-lattice exhibits a magnetic moment, $\mathbf{m}_B$. The magnetic moments of the atoms A of the first sub-lattice and the magnetic moments of the atoms B of the second sub-lattices are aligned parallel to an axis of orientation but in the opposite directions and have the same magnitude (i.e. $m_A = m_B$) resulting a zero net spontaneous magnetization.

In the examples of ferromagnetic, ferrimagnetic and antiferromagnetic materials hereinbefore described, the magnet moments are aligned parallel to an axis of orientation and are orientated in a parallel or an anti-parallel direction. However, there are antiferromagnetic materials in which magnet moments are canted, but have a zero net spontaneous magnetization.

Figure 3b illustrates an example of an antiferromagnetic material comprising a lattice which includes a first sub-lattice which comprises atoms A of a first magnetic element, a second sub-lattice which comprises atoms B of a second magnetic element and a third sub-lattice which comprises atoms C of a third magnetic element. Each atom A in the first sub-lattice exhibits a magnetic moment, $\mathbf{m}_A$, each atom B in the second sub-lattice exhibits a magnetic moment, $\mathbf{m}_B$,

and each atom C in the third sub-lattice exhibits a magnetic moment, $m_C$. The magnetic moments of the atoms A, B, C are not oriented parallel to an axis of orientation, but are orientated such that they result a zero net spontaneous magnetization.

In the case of a magnetically-ordered material, such as a three sub-lattice antiferromagnetic material, in which magnet moments in different sub-lattices are not aligned parallel to an axis of orientation, a notional (or representative) axis of orientation can be assigned. A notional axis of orientation (even where there is no actual axis of orientation) can help when describing re-orientation of magnetic moments.

An axis of orientation depends on angle, but not polarity. Thus, for example, first and second vectors (such as magnetic moments) which are orientated parallel and anti-parallel respectively along the same axis have the same axis of orientation, but have different (i.e. opposite) polarities (i.e. they have parallel and anti-parallel orientations).

An external magnetic field (as well as other forms of applied bias, such as spin transfer torque current and strain) can be used to re-orientate magnetic moments in a ferromagnetic material, ferrimagnetic material and an antiferromagnetic material.

As will now be explained in more detail, re-orientation of magnetic moments can lead to a change in chemical potential which can be employed in a field-effect transistor to induce charge and thus control channel conductance.

**Field-effect transistor 1**

*Device structure*

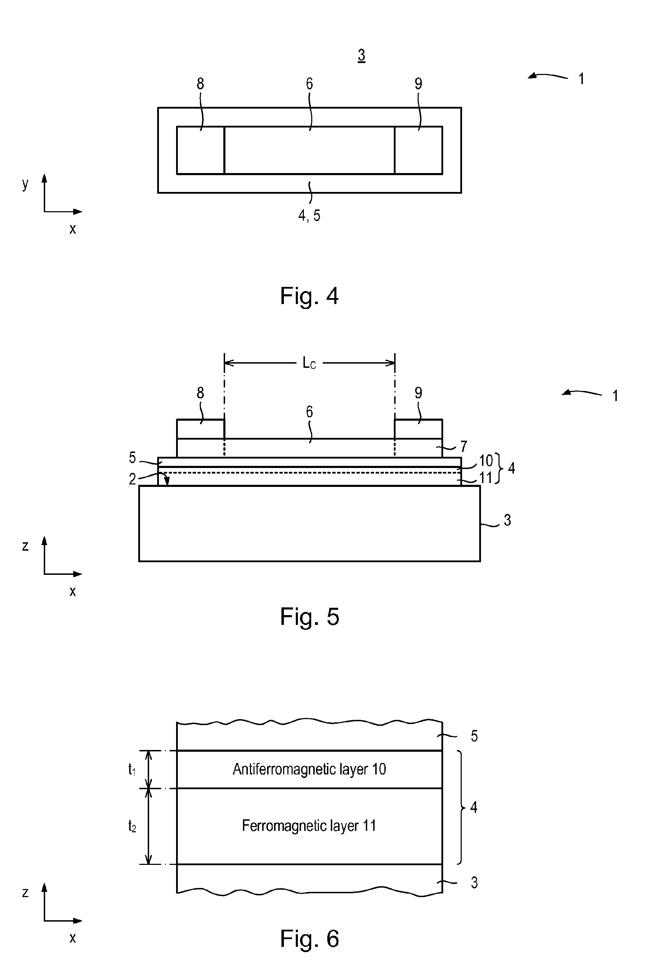

Referring to Figures 4 to 6, a first field-effect transistor 1 in accordance with the present invention is shown.

The field-effect transistor 1 is formed on an upper surface 2 of a silica glass substrate 3. The transistor 1 has a bottom-gate structure comprising a gate electrode 4 disposed on the upper surface 2 of the substrate 3 and a gate dielectric 5 separating the gate electrode 4 from a conductive channel 6 formed in a layer 7 of graphene. The gate dielectric 5 comprises a high-k dielectric material, such as hafnium dioxide ($HfO_2$). A pair of spaced-apart titanium/gold (Ti/Au) pads 8, 9 are disposed on the graphene layer 7 to provide first and second contacts (herein also referred to as "source" and "drain" contacts) to the graphene layer 7 thereby defining the channel 6 having a length, $L_C$. The channel 6 is continuous. In particular, the channel 6 is not divided into regions forming discrete conductive islands and tunnel barriers. Thus, the transistor 1 is configured for non-correlated charge transport, i.e. the transistor 1 is not configured to exhibit Coulomb blockade.

The gate electrode 4 is arranged to gate the channel 6 along the length of the channel 6. In some embodiments, for example in which the transistor has a top-gate arrangement, the gate electrode 4 has a length, $L_G$, and is arranged such that most, for example at least about 80%, of the length of the channel is gated by the gate electrode, i.e. $L_G \geq 0.8\, L_C$.

A first region 10 of the gate electrode 4 which is closest to the conductive channel 6 (in this example, the uppermost part of the gate electrode 4) comprises a magnetically-ordered material. The magnetically-ordered material may be antiferromagnetic, ferrimagnetic or ferromagnetic. A second region 11 of the gate electrode 4 is in direct contact with the first gate region 10 and is arranged further away from the channel 6 (i.e. the first region 10 is interposed between the channel 6 and the second region 11) and is also magnetically ordered. Orientation of magnetic moments in the first and second regions 10, 11 can be the same. However, in some examples, orientation of magnetic moments in the first and second regions 10, 11 can differ.

As will be explained in more detail later, the gate electrode 4 may comprise a single layer and so the first and second regions 10, 11 may be different regions of the same layer of magnetically-ordered material. However, the gate electrode 4 may comprise more than one different layers of magnetically-ordered material arranged in a multilayer stack structure.

Referring to also Figure 6, in the first field-effect transistor 1, the first region 10 of the gate electrode 4 comprises a thin (e.g. $20 > t_1 > 1$ nm) layer of antiferromagnetic material, such as iridium manganese (IrMn), and the second region 11 comprises a thicker (e.g. $t_2 > 20$ nm) layer of ferromagnetic material, such as Permalloy. Permalloy is an alloy of iron (Fe) and nickel (Ni), for example, in a ratio of about 20:80.

The orientation of magnetic moments of the gate electrode 4 can be used to control charge transport through the channel 6, as will now be described in more detail.

*Device operation*

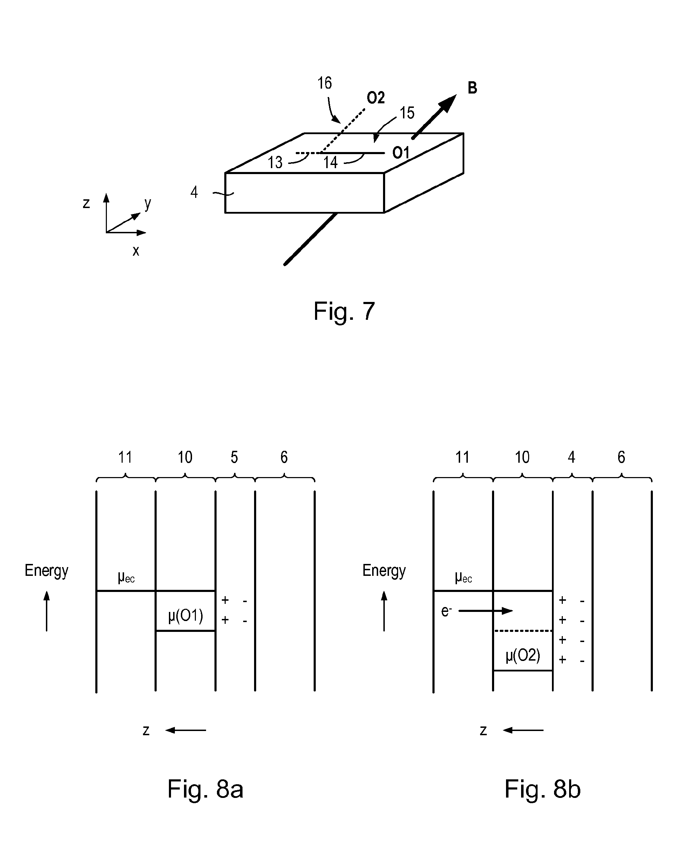

Referring also to Figure 7, the gate electrode 4 is at least uniaxial and so has at least one easy axis 13 parallel to which an axis of orientation 14 can be orientated in the absence of an external magnetic field. In the case of a ferromagnetic material, a ferrimagnetic material or an antiferromagnetic material having two sub-lattices, magnetic moments are aligned parallel to the axis of orientation and can be orientated in parallel or anti-parallel directions. In this example, the easy axis 13 is arranged in plane, i.e. in the plane of the layer(s). In the case of a ferromagnetic material or a ferrimagnetic material, orientation of magnetic moments is reflected in (i.e. represented by) the orientation of magnetization.

In the case of an antiferromagnetic material having three or more sub-lattices, magnetic moments have a (fixed) relationship with respect to the notional axis of orientation. Thus, when magnetic moments are re-orientated, the notional axis of orientation is also re-orientated.

The magnetic moments can be re-orientated from being parallel to (or having some other relationship to) a first axis of orientation 15 (herein also referred to O1) to a second axis of orientation 16 (herein also referred to as O2), for example by applying an external magnetic field **B**, by driving a spin-torque transfer current and/or by applying mechanical strain.

Magnetic moment re-orientation results in change of gate chemical potential, $\mu$, and, thus, a change in conductance in the channel 6. Electrochemical potential, $\mu_{ec}$, of the gate electrode 4 is not affected by magnetic moment re-orientation.

Referring also to Figures 8a and 8b, re-orientation of magnetic moments 14 causes a shift, $\Delta\mu$, in the chemical potential, $\mu$. A change, $\Delta\mu$, in chemical potential in the region 10 proximate to the channel 6 causes inward or outward flow of charge resulting in a change in charge offset and, thus, potential across the gate dielectric 5. Although the change, $\Delta\mu$, in chemical potential can be small, for example having an order of magnitude of 1 meV, 10 meV or more (for example, between 1 meV and 20 meV), then the effect of change in chemical potential on transport in the channel 6 can still be significant if a gate voltage bias, Vg, is chosen at which a small additional change of gate bias causes a large change in conductance of the channel 6. This can, for example, be close to a threshold gate bias, $Vg^{TH}$, the gate bias above which the channel is conductive, i.e. Vg > $Vg^{TH}$.

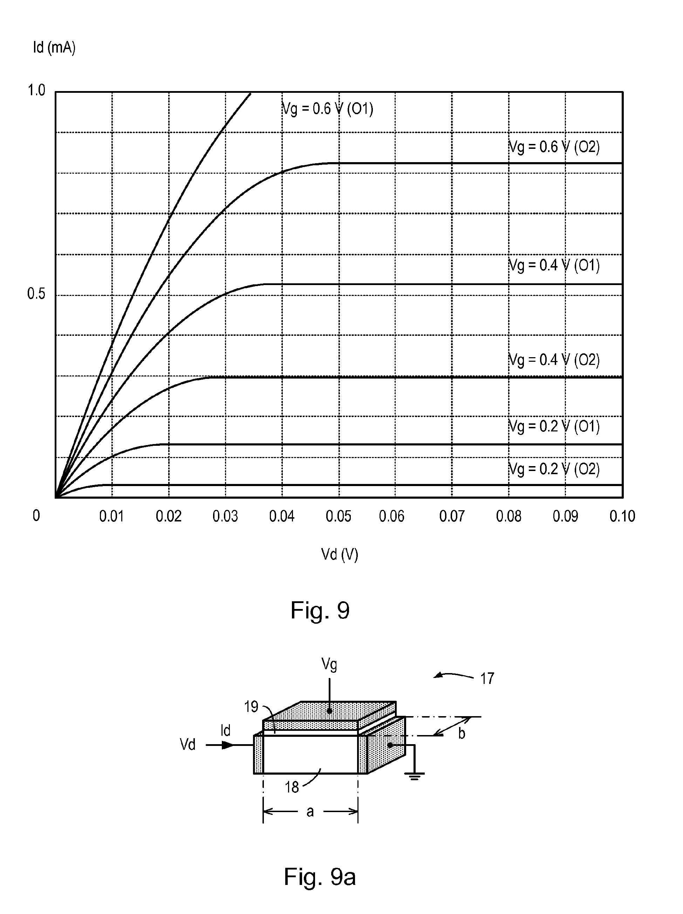

Referring to Figures 9 and 9a, the effect of a change in chemical potential of a gate electrode can be modelled for a field-effect transistor 17. In this case, transistor 17 has a silicon channel 18 and a silicon dioxide gate dielectric 19.

Figure 9 shows an analytical simulation of source-drain current, Id, against source-drain voltage, Vd, for three different values of gate voltage, Vg, namely +0.2V, +0.4V and +0.6V and two different axes of orientation, **O1** and **O2**, for which $\mu($**O1**$)$- $\mu($**O2**$)$ = 10 meV, for the silicon-channel field-effect transistor 17. The field-effect transistor 17 has a channel length, a, of 1 $\mu$m, a channel width, b, of 2000 $\mu$m, a channel mobility of 1000 $cm^2V^{-1}s^{-1}$ and channel doping of about $2\times10^{15}$ $cm^{-3}$, a gate dielectric thickness of 10 nm and a gate capacitance of about $3.5\times10^{-7}$ $Fcm^{-2}$ and a threshold voltage of 0.7 V.

As shown in Figure 9, changes in orientation of magnetic moments can result in appreciable changes in source-drain current, Id.

Thus, a field-effect transistor having a magnetically-ordered gate such as that shown in Figures 4 to 6 can be used as a magnetic field sensor.

Furthermore, if the gate electrode 4 exhibits at least biaxial magnetic anisotropy (for example biaxial magnetic anisotropy or n-fold magnetic anisotropy, where n >2) such that it has at least two magnetic easy axes thereby resulting in at least two different stable orientations of magnetic moments (i.e. two stable states) having different chemical potentials, then the transistor can also operate as a non-volatile memory device.

**Field-effect transistor 21**

As explained earlier, the field-effect transistor 1 (Figures 4 to 6) can operate a non-volatile memory device if the gate electrode 4 (Figures 6 to 6) exhibits at least biaxial magnetic anisotropy. If the gate electrode 4 (Figures 4 to 6) exhibits uniaxial magnetic anisotropy, the gate electrode 4 can exhibit two different stable states, i.e. parallel and anti-parallel states, but these two states have the same chemical potential and so produce the same indistinguishable effect on charge transport in the channel.

However, a gate electrode which comprises ferromagnetic or ferrimagnetic region and which exhibits uniaxial magnetic anisotropy can be used as a memory device if further stable state(s) can be introduced (for example, by introducing a pinning centre or region for a domain wall) and/or if temporal changes in chemical potential (for example, due to passage of a domain wall) can be detected.

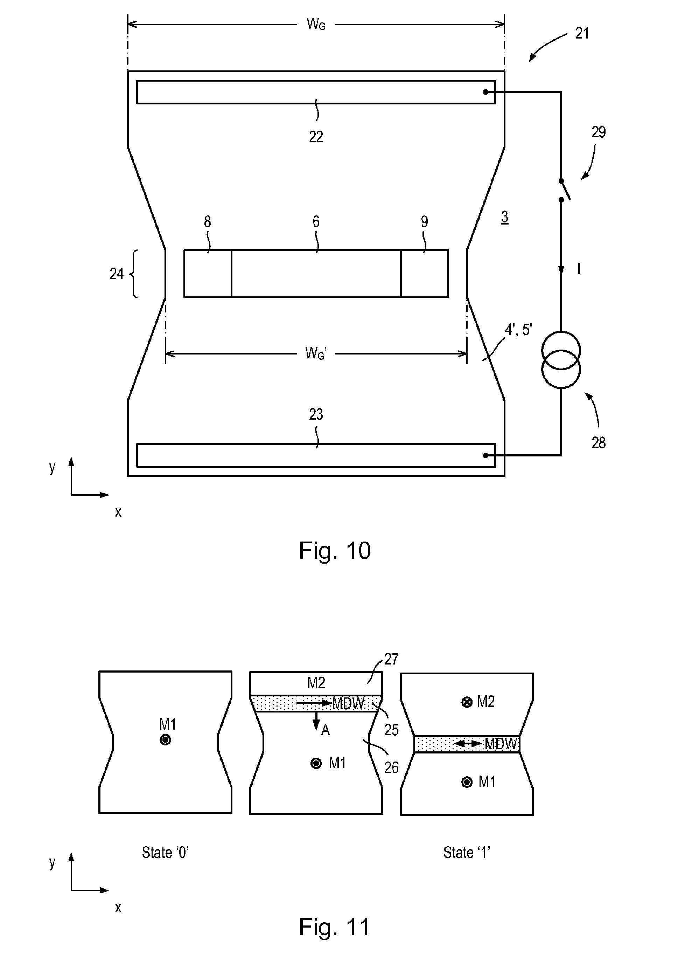

A field-effect-transistor 21 is shown in Figure 10 which has a modified gate configuration 4' and additional elements 22, 23 which allows the gate electrode to be used in a different way and for changes in chemical potential to be detected.

In the following like reference numerals are used to refer to like features.

*Device structure*

Referring to Figure 10, a second field-effect transistor 21 in accordance with the present invention is shown.

As shown in Figure 10, the second field-effect transistor 21 is similar to the first field-effect transistor 1 (Figure 4). For example, the second field-effect transistor 21 comprises a channel 6 formed in a layer 4 of graphene disposed on a silica glass substrate 2 and first and second contacts 8, 9.

The second transistor 21 differs from the first transistor 1 (Figure 4) in that it has a striped gate electrode 4' which generally runs in a direction (in this the case, the y-direction) across the channel 6 (which in this case runs along the x-direction). The gate electrode 9' has a width, $W_G$, which is larger than the length, $L_G$, of the conductive channel between the source and drain 9, 10, and a waist 24 having a narrower width, $W_G'$ which is equal to or larger than the length, $L_G$, of the conductive channel between source and drain 9, 10. The stripe width, $W_G$, is smaller than or equal to the maximum length along which a single domain wall propagates coherently. The stripe width, $W_G$, may be no more than 10 $\mu$m, no more than 1 $\mu$m or no more than 100 nm. The stripe width, $W_G$, is preferably at least 10 nm. The ratio $W_G'/W_G$ may be no more than 0.9, but at least 0.1. The waist 24 serves as a pinning centre for a domain wall 25 which can propagate back and forth along the striped gate electrode 4'. Additional or alternative forms of pinning centre can be provided. For example, pinning centres may be generated by focused ion-beam irradiation of a region of the gate electrode 4' above the conductive channel 6. Ion irradiation using, for example, helium ions or gallium ions, can change the magnetic anisotropy of the irradiated areas of the gate electrode 4' causing the domain wall to be pinned. Also, local strain variations may be used to pin the domain wall above the conductive channel 6.

The second transistor 21 includes first and second contacts 22, 23 formed of non-magnetic metal, to the gate electrode 4' for driving a current I through the gate electrode 4' in a direction perpendicular to the channel 6. The current is used to drive a domain wall 25 separating two domains 26, 27 back and forth, for example forwards in direction A.

The gate electrode 4' comprises a layer of ferromagnetic material, such as CoPt, and is configured to exhibit uniaxial magnetic anisotropy. In this example, the ferromagnetic layer exhibits out-of-plane magnetic anisotropy.

As shown in Figure 10, the domain wall 25 separates two domains 26, 27 which are directed in opposite directions, i.e. in one domain 26 the magnetization **M1** is directed along the magnetic easy axis (not shown) and in the other domain 27 the magnetization **M2** is anti-parallel to **M1**. In this case, magnetization **M1** and **M2** are parallel to the axis of orientation **O1**. In the domain wall 25, magnetisation **MDW** in the centre of the wall 25 is rotated and is orientated neither parallel nor anti-parallel. For example, the magnetisation **MDW** in the centre of the domain wall 25 may be directed in plane.

Thus, the magnetization **MDW** has a different axis of orientation, **O2.** Thus, the chemical potential of the gate electrode 9' in the region of the domain wall $\mu$(**MDW**) $\neq$ $\mu$(**M1**) = $\mu$(**M2**).

A current source 28 which can drive currents in both directions a switch 29 are used to move the domain wall 25 back and forth and, thus, switch the gate electrode 4' between two stable states, for example, shown in Figure 11.

*Device operation*

As explained earlier, conductance of the channel 6 varies according to the chemical potential of the gate electrode 4'.

In this case, the channel 6 is used to probe a section of the gate electrode 4', namely in the waist 24 of the gate electrode 3', and to detect when the domain wall 25 is pinned over the channel 6.

In some embodiments, the gate electrode 4' may exhibit n-fold magnetic anisotropy (where n $\geq$ 2). Thus, the first and second magnetizations **M1, M2** need not be parallel and anti-parallel with respect to one of magnetic easy axis (not shown).

**Current-generating device 41**

A magnetically-ordered gate in which magnetic moment orientation time-varies can be used to time-vary chemical potential and, in turn, to generate a time-varying current.

*Device structure*

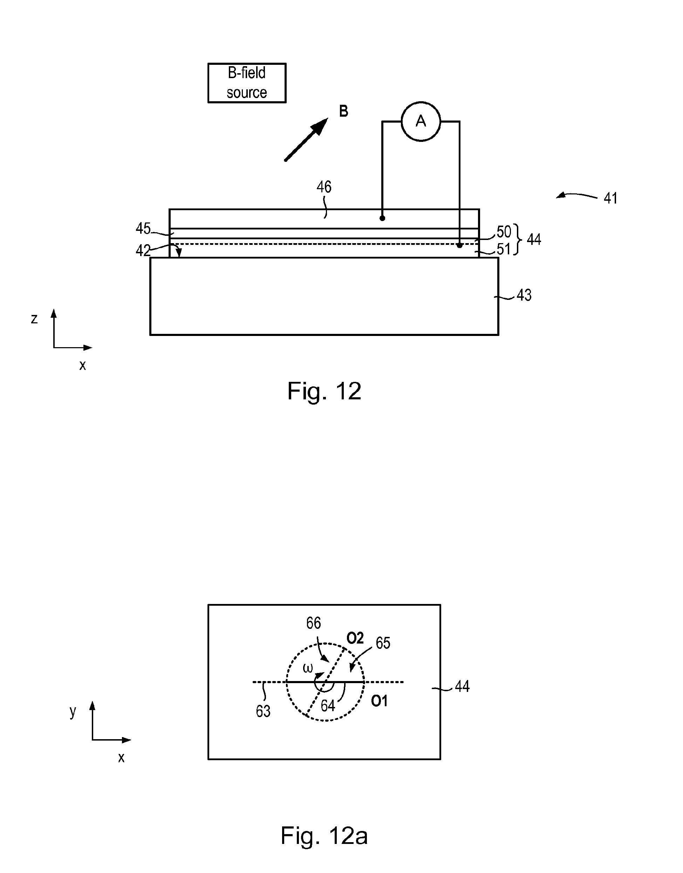

Referring to Figure 12, a device 41 for generating a current in accordance with the present invention is shown.

The current-generating device 41 is formed on an upper surface 42 of a silica glass substrate 43. The device 41 comprise a first electrode 44 (or "first plate") disposed on the upper surface 42 of the substrate 43 and a dielectric 45 separating the first electrode 44 from a second, counter electrode 46 (or "second plate"). The dielectric 45 comprises a high-k dielectric material, such as hafnium dioxide ($HfO_2$).

A first region 50 of the first electrode 44 which is closest to the second electrode 46 (in this example, the uppermost part of the first electrode 44) comprises a magnetically-ordered material. The magnetically-ordered material may be antiferromagnetic, ferrimagnetic or ferromagnetic. A second region 61 of the first electrode 44 is in direct contact with the first region 50 and is arranged further away from the second electrode 46 and is also magnetically ordered.

The first electrode 44 may comprise a single layer and so the first and second regions 50, 51 may be different regions of the same layer. However, the first electrode 44 may comprise more than one different layers arranged in a multilayer stack structure.

The first region 50 of the first electrode 44 comprises a thin (e.g. 20 > $t_1$ > 1 nm) layer of antiferromagnetic material, such as iridium manganese (IrMn), and the second region 51 comprises a thicker (e.g. $t_2$ > 20 nm) layer of ferromagnetic material, such as Permalloy.

The second electrode 46 comprises a non-magnetic conductive material, such as gold (Au). However, the counter electrode 46 may also be or comprise a region of magnetically-ordered material proximate to the first electrode 44. In the case that the second electrode 46 is or comprises a region of magnetically-ordered material, it is configured so that chemical potential anisotropies are not identical but, for example, vary out of phase with respect to one another in the presence of the same magnetic field.

*Device operation*

The first and second electrodes 44, 46 form a parallel plate capacitor in which one (or both) of the electrodes 44, 46 is susceptible to a magnetic field and /or to mechanical strain.

The first electrode 44 exhibits a magnetic moment orientation-dependent chemical potential at its interface with the dielectric 45. Optionally, the second electrode 46 may also exhibit a magnetic moment orientation dependent chemical potential at its interface with gate dielectric 45

The first electrode 44 and optionally the second electrode 46 may comprise a layer of ferromagnetic material, a layer of ferrimagnetic material, a layer of antiferromagnetic material, or a layer of antiferromagnetic material exchange-coupled to layer(s) of ferromagnetic material.

In the first electrode 44, magnetically-ordered moments at the interface with the dielectric layer 45 are time-dependently (e.g. periodically) changed between at least two first and second axes of orientation 64, 65 where chemical potential differs by $\Delta\mu = \mu(\mathbf{O1}) - \mu(\mathbf{O2})$.

If both electrodes 44, 46 are magnetically-ordered, than $\Delta\mu$(first electrode 44) is arranged to be different from $\Delta\mu$(second electrode 46). This can be achieved by using different magnetically-ordered materials in the electrodes 44, 46 and/or by using materials and/or configurations which have different magnetic susceptibilities so that $\mathbf{O1}$(first electrode 44) is not simultaneously equal to $\mathbf{O1}$(second electrode 46) and/or that $\mathbf{O2}$(first electrode 44) is not equal to $\mathbf{O2}$(second electrode 46) at the same time during a cycle.

Changing the orientation of magnetic moments in a magnetically-ordered electrode 44, 46 can be achieved by different ways.

If the magnetically-ordered electrode 44, 46 (which may take the form of an antiferromagnetic layer which is exchange-coupled to a ferromagnetic layer) is susceptible to an applied magnetic field $\mathbf{B}$, then periodically applying or sweeping the magnetic field $\mathbf{B}$ along a hard magnetic axis (not shown) re-orientates the axis of orientation 64, changing it from a first orientation 65 (i.e. $\mathbf{O1}$) parallel to the easy axis 63 to a second orientation 66 (i.e. $\mathbf{O2}$). Alternatively, a rotating saturation field can be used to periodically rotate the axis of orientation 65 from the first orientation 65 (i.e. $\mathbf{O1}$) to the second orientation 66 (i.e. $\mathbf{O2}$).

If the magnetically-ordered electrode 44, 46 is susceptible to strain, then periodically applying strain to the electrode 44, 46 can periodically re-orientate the axis of orientation 64, changing it from the first orientation 65 to a second orientation 66.

If a change in magnetic moment orientation is realized in a short time, $\tau$, and the axis of orientation changes between $\mathbf{O1}$ and $\mathbf{O2}$, the device will generate a single current pulse $I_p$, namely:

$$I_p = C/e \ (\mu(\mathbf{O1}) - \mu(\mathbf{O2})/\tau \qquad\qquad (1)$$

If the capacitor 41 has a capacitance C, e is the electron charge, and the axis of orientation changes between $\mathbf{O1}$ and $\mathbf{O2}$ at a frequency $\omega$, then an ac current, $I_{ac}$, is generated by the device is equal to

$$I_{ac} = C/e \ d\mu/dt = C/e \ \Delta\mu \ \omega \ \sin(\omega t) \qquad\qquad (2)$$

For example, if C = 1 $\mu$F and $\omega$ = 1kHz and $\Delta\mu$ = 10 meV, then than $I_{ac}$ = 10 $\mu$A.

If both electrodes 44, 46 exhibit simultaneous different magnetic chemical potential anisotropies, $\Delta\mu 1$ and $\Delta\mu 2$, then

$$I_{ac} = C/e \ (\Delta\mu_1 - \Delta\mu_2) \ \omega \ \sin(\omega t) \qquad\qquad (3)$$

If both electrodes 44, 46 exhibit the same magnetic chemical potential anisotropy, i.e. $\Delta\mu_1 = \Delta\mu_2$, but the axis of orientation of the first electrode 44 is not the same as the axis of orientation in the second (magnetically-ordered) electrode 46 at the same time (for example at the same time, the axis of orientation in the first electrode 44 is **O1** and the axis of orientation in the second electrode 46 is **O2** and *vice versa*), then

$$I_{ac} = C/e \ 2 \ \Delta\mu \ \omega \ \sin(\omega t) \qquad\qquad (4)$$

Thus, by using two magnetically-ordered electrodes 44, 46 a greater current can be generated.

**Fabrication**

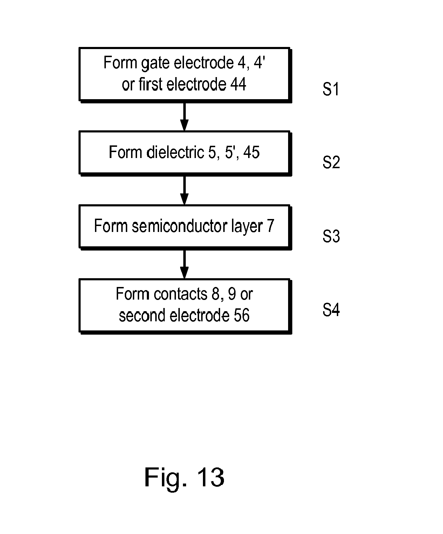

Referring to Figures 4, 5, 10, 12 and 13, a method of fabricating the devices 1, 21,41 will now be described.

A silica glass substrate 3, 43 is provided and can be cleaned, for example, by rinsing in de-ionized water, rinsing in acetone then isopropynol alcohol and in an oxygen plasma.

A gate electrode 4, 4', 44 and a dielectric layer 5, 5', 45 are sequentially formed on the substrate (steps S1 & S2). A layer of photoresist (not shown) is spin-coated onto the substrate 43 and is patterned to form a window (not shown) defining the extent of the gate electrode 4, 4' or first electrode 44, and the (gate) dielectric 5, 5' 55. The masked substrate (not shown) is loaded into a sputter coater or thermal evaporator (not shown) and layer(s) of magnetic material is (are) deposited at low pressure. The coated substrate can be loaded into reactor (not shown) and a layer of $HfO_2$ (or other high-k dielectric) is deposited b atomic layer deposition (ALD). The coated substrate is unloaded and unwanted regions of the deposited layers are removed by lift off in acetone.

In the case of the transistors 1, 21, the semiconductor layer 7 is formed (step S3). A process of graphene deposition and patterning is described in A. Turchanin et al.: "Conversion of Self-Assembled Monolayers into Nanocrysalline Graphene: Structure and Electric Transport", ACS Nano, volume 5, pages 3896 to 3904 (2011).

The contacts 8, 9 are formed on the patterned graphene layer 7 (step S4). This can be achieved using a lift-off process employing optical lithography and sequentially depositing a layer of titanium (to promote adhesion) and then a layer of gold by sputtering or thermal evaporation. The step can be used to form the second electrode 56. Suitable materials can be used to form a non-magnetic electrode or a magnetically-ordered electrode.

It will be appreciated that many modifications may be made to the embodiments hereinbefore described.

For example, the source and drain and channel may be coplanar. Thus, a device similar to a metal-oxide-semiconductor field-effect transistor (MOSFET) can be used. Such a device is usually top gated. A top-gated Si-MOSFET can be formed using a high-resistivity, undoped silicon substrate. The channel may be formed in the substrate (i.e. from undoped silicon) and the contacts may take the form of diffusion wells (for example, using phosphorous or another dopant) to a peak concentration between $10^{20}$ cm$^{-3}$ and $10^{21}$ cm$^{-3}$. After depositing, a dielectric layer of $SiO_x$ or a high-k dielectric, a magnetically-ordered gate is sputtered, thermally evaporated or e-beam evaporated on top of the dielectric layer. When a voltage above the threshold is applied to the gate electrode, a channel is formed in the substrate under the gate.

An additional gate electrode and a corresponding gate dielectric may be provided so as to provide a top- and bottom-gated channel. One gate electrode may be magnetically ordered and the other gate electrode may be non magnetic. The non-magnetic gate electrode may be used to bring the transistor to an operating point, e.g. to or close to threshold, and the magnetically-ordered gate may be used to control conductance in the channel.

Re-orientation of magnetisation can be achieved by applying mechanical strain. This can be applied by using a piezoelectric actuator, for example, glued to the substrate.

**Claims**

**1.** A field-effect transistor (1; 21) comprising:

a conductive channel (6) comprising a non-magnetic material;
first and second contacts (8, 9) to the channel;
a gate electrode (4) for applying an electric field to the channel; and
a gate dielectric (5) separating the gate electrode from the channel;

wherein the gate electrode is arranged to gate the channel substantially along the length of the channel and wherein a region (10) of the gate which is proximate to the channel comprises a magnetically-ordered material having a chemical potential which depends on orientation of magnetic moments in the gate region.

2. A field-effect transistor according to claim 1, wherein the magnetically-ordered material is an antiferromagnetic material.

3. A field-effect transistor according to claim 1, wherein the magnetically-ordered material is a ferrimagnetic material.

4. A field-effect transistor according to claim 1, wherein the magnetically-ordered material is a ferromagnetic material.

5. A field-effect transistor according to any preceding claim, the change of chemical potential is at least 1 meV, at least 2 meV, at least 5 meV or at least 10 meV.

6. A field-effect transistor according to any preceding claim, wherein the gate electrode (4) comprises a further region (11) directly in contact with the region which is proximate to the channel, the further region comprising a ferromagnetic material

7. A field-effect transistor according to any preceding claim wherein the gate region (10) exhibits at least bi-axial magnetic anisotropy.

8. A field-effect transistor according to any preceding claim, wherein the gate dielectric (5) comprises a high-k dielectric material.

9. A field-effect transistor according to any preceding claim, wherein the non-magnetic material comprises graphene.

10. A device according to any one of claims 1 to 9, wherein the gate electrode (4) is configured to exhibit first and second stable states, said first and second stable states having different values of chemical potential.

11. A device according to any one of claims 1 to 9, wherein the gate electrode (4) is configured to exhibit first and second stable states, said first and second stable states having substantially the same chemical potential, the gate electrode is further configured to switch between the first and second stable states through domain wall propagation.

12. A magnetic field sensor comprising at least one field-effect transistor according to any preceding claim.

13. A memory device comprising at least one transistor according to any preceding claim.

14. A current-generating device (41) comprising:

first and second electrodes (44, 46) separated by a dielectric (45); 1
wherein a region (50) of first electrode (44) which is proximate to the second electrode (46) comprises a magnetically-ordered material having a chemical potential which depends on orientation of magnetic moments in the region of the first electrode.

15. A device according to claim 14, wherein the a region of second electrode (44) which is proximate to the first electrode comprises a magnetically-ordered material having a chemical potential which depends on orientation of magnetic moments in the region of the second electrode

16. A method of operating a device according to claim 14, further comprising:

applying a load between the first and second electrodes (44, 46); and
changing orientation of magnetic moments (64) in the first electrode (44) for a given time.

**17.** A method of operating a device according to claim i5 or 16, further comprising:

applying a load between the first and second electrodes (44, 46); and
changing orientation of magnetic moments (64) in the first electrode (44).

Example of
ferromgnatic order

Axis of orientation

$m_A$

A

M

Fig. 1

Example of
ferrimagnetic order

Axis of orientation

$m_A + m_B \neq 0$

$m_A$

A     B

$m_B$

$m_A$ $m_B$

M

Fig. 2

First example of
antiferromagnetic order

Axis of orientation

$m_A + m_B = 0$

$m_A$

A     B

$m_B$

$m_A$ $m_B$

Fig. 3a

Second example of
antiferromagnetic order

Notional axis of orientation

$m_A$

B     A
$m_B$

$m_C$
C

$m_A + m_B + m_C = 0$

$m_B$     $m_A$

$m_C$

Fig. 3b

**Fig. 4**

**Fig. 5**

**Fig. 6**

Fig. 7

Fig. 8a

Fig. 8b

Fig. 9

Fig. 9a

Fig. 10

State '0'                                                   State '1'

Fig. 11

B-field source

**B**

Ⓐ

46

45

42

50 51 } 44

43

← 41

z
x

## Fig. 12

66

**O2** 65

ω

63

64

**O1**

44

y
x

## Fig. 12a

```
┌─────────────────────────┐
│  Form gate electrode 4, 4' │      S1
│    or first electrode 44   │
└─────────────────────────┘
             │
             ▼
┌─────────────────────────┐
│   Form dielectric 5, 5', 45 │     S2
└─────────────────────────┘
             │
             ▼
┌─────────────────────────┐
│  Form semiconductor layer 7 │    S3
└─────────────────────────┘
             │
             ▼
┌─────────────────────────┐
│    Form contacts 8, 9 or   │     S4
│    second electrode 56     │
└─────────────────────────┘
```

Fig. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5652445 A

- EP 1830410 A

**Non-patent literature cited in the description**

- **A. TURCHANIN et al.** Conversion of Self-Assembled Monolayers into Nanocrysalline Graphene: Structure and Electric Transport. *ACS Nano,* 2011, vol. 5, 3896-3904